# EUROPEAN PATENT SPECIFICATION

(11) **EP 0 331 223 B1**
(45) Date of publication and mention of the grant of the patent: **17.05.1995**
(21) Application number: 89200327.8
(22) Date of filing: 13.02.1989
(51) Int. Cl.: H01L 21/82, H01L 29/78

(54) **Process for obtaining high-voltage N channel transistors particularly for EEPROM memories with CMOS technology**
Verfahren zur Herstellung eines N-Kanal-Transistors für Hochspannung, insbesondere für EEPROM-Speicher mit CMOS-Technologie
Procédé de fabrication d'un transistor à canal du type N, notamment pour mémoire EEPROM avec technologie CMOS

(30) Priority: 29.02.1988 IT 1958088
(43) Date of publication of application: 06.09.1989
(73) Proprietor: SGS-THOMSON MICROELECTRONICS s.r.l., 20041 Agrate Brianza (Milano) (IT)
(72) Inventor: Riva, Carlo, I-20052 Monza (Milano) (IT)
(74) Representative: Mittler, Enrico

(56) References cited:
- EP-A- 0 123 936
- EP-A- 0 169 600
- EP-A- 0 173 953
- EP-A- 0 189 208

## Description

The present invention relates to a process for obtaining high-voltage N channel transistors particularly for EEPROM memories with CMOS technology.

Various processes for obtaining high-voltage N channel transistors are known and can be found in the literature. One of these which is commonly known with the name LDD (Lightly Doped Drain) and is described, for example, in the article "Design and Characteristics of Lightly Doped Drain-Source (LDD) Insulated Gate Field-Effect Transistor", IEEE Transaction on Electron Devices, vol. ED-27, pp. 1359-1360, 8 August 1980, is used particularly for selection and external circuitry transistors in EEPROM memories with CMOS technology and comprises for each transistor, in succession, the steps of deposition and definition of a layer of polysilicon on a semiconductor substrate covered with gate oxide for the formation of a gate area, N⁺ doping of a first predetermined portion of the substrate on one side of said gate area for the formation of a source area and of a second predetermined portion of the substrate on the other side of said gate area and spaced therefrom for the formation of a drain area and finally the N⁻ doping of an intermediate portion of the substrate between said gate area and said drain area for the formation of an extension of the drain area with Lower N doping.

In this manner the drain junction near the gate has low-concentration doping which permits limiting the electric field in that zone between gate and diffusion and consequently amplification of the working voltage field which the transistor is able to accept without breaking the gate oxide between the drain and the gate.

In a quite similar manner, starting from N substrates and performing P doping instead of N doping it is possibile to use the same process to obtain high voltage P channel transistors.

The object of the present invention is to provide a process for obtaining high voltage N channel transistors which would be usable in place of the known process mentioned above to obtain the N channel transistors of an EEPROM memory with CMOS technology.

In accordance with the invention said object is achieved by a process as defined in claim 1.

By this process, which is usable simultaneously for the high-voltage selection transistors and the external circuitry transistors of an EEPROM memory, there are obtained high-voltage N channel transistors with the desired low-concentration drain doping under the gate so as to limit the electric field in that zone.

Application of the process in accordance with the invention to provide a selection transistor and an external circuitry transistor, both high-voltage N channel, for an EEPROM memory with CMOS technology will now be described in detail for greater clarity with reference to the annexed drawings wherein -

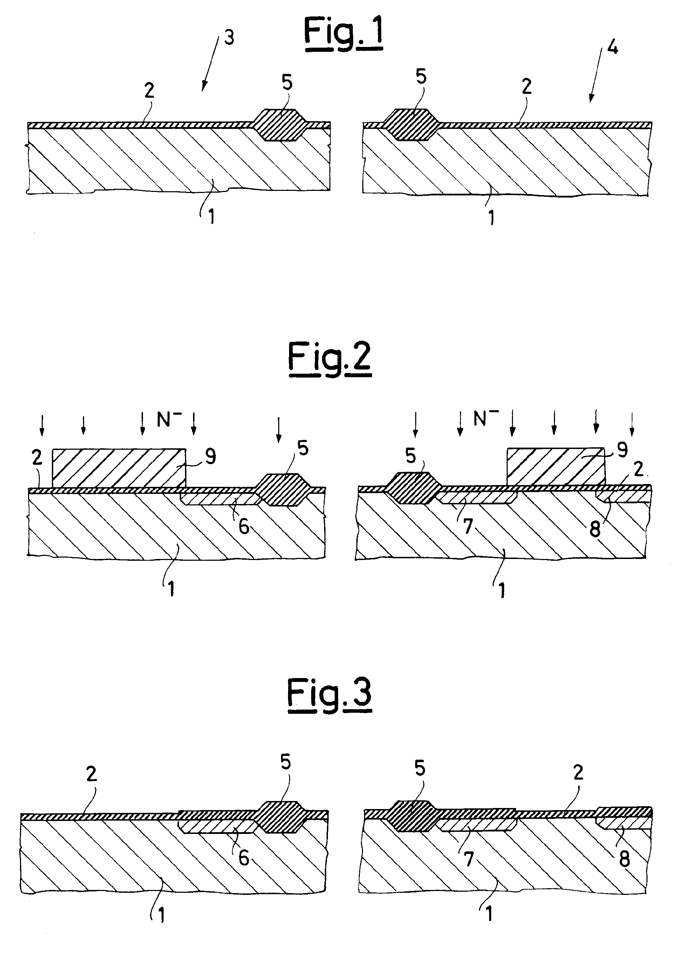

FIGS. 1-6 show in succession the main steps of said process.

FIG. 1 shows a P-type semiconductor substrate 1 covered by a layer of oxide 2 provided on the active areas 3 and 4 defined between field oxide zones 5. The area 3 is designed for formation of a selection transistor for an EEPROM cell while the area 4 is designed for formation of a high-voltage external circuitry transistor.

As shown in FIG. 2 a predetermined surface portion 6 of the substrate in the area of the selection transistor and two predetermined spaced surface portions 7 and 8 of said substrate are subjected to N⁻ doping (e.g. phosphorous with doses between 10¹³ and 10¹⁴ atoms of phosphorous/cm³) using a resist mask 9 to protect the surface portions which are not to receive the dope.

The resist is then removed and the entire substrate surface is oxidized. In a known manner the oxide grows more on the surface portions previously doped (FIG. 3).

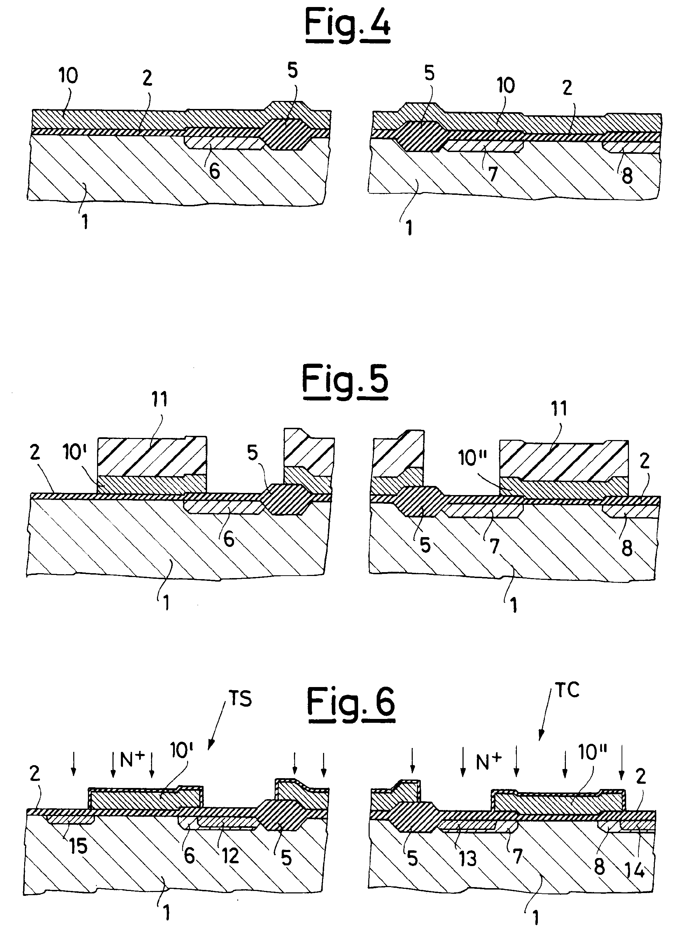

The following step calls for deposition of a layer of polysilicon 10 which is then N⁺ doped (FIG. 4).

Another resist mask 11 subsequently allows definition of the polysilicon 10 in the form of two strips 10′ and 10˝ of which the first is superimposed on a side part of the substrate surface portion 6 with N⁻ doping and an adjacent undoped surface portion of said substrate and the second is superimposed on faced side parts of the substrate surface portions 7 and 8 with N⁻ doping and on the interposed undoped surface portion of said substrate (FIG. 5). The two strips of polysilicon 10′ and 10˝ are designed to form the gates of the two transistors being produced.

After removal of the resist and a subsequent oxidation there is performed N⁺ doping of the remaining parts 12, 13, 14, 15 of the substrate surface portions 6, 7, 8 and of another surface portion 15 located on the side of the gate 10′ opposite the surface portion 6 (FIG. 6). The surface portions 15 and 13 thus become the N⁺ source areas of the selection and external circuitry transistors respectively while the surface portions 12 and 14 become the N⁺ drain areas of said transistors, having respective portions 6 and 8 with N⁻ doping under the gates 10′ and 10˝.

There are thus obtained a selection transistor TS and an external circuitry transistor TC, both with high-voltage N channel (FIG. 6).

## Claims

1. Process of forming simultaneously a plurality of high-voltage N channel transistors particularly for EEPROM memories with CMOS technology characterized in that it comprises for each transistor, in succession, the steps of :
(a) N⁻ doping of a predetermined surface portion (6, 8) of a type-P semiconductor substrate (1), said substrate being preliminarly covered with gate oxide (2),
(b) oxidation of the substrate surface,
(c) deposition and definition of an N⁺ doped polysilicon layer (10) for formation of a polysilicon gate strip (10′, 10˝) on a side part of said predetermined surface portion (6, 8) and on an adjacent surface portion of the substrate,
(d) oxidation of the polysilicon gate strip (10′, 10˝) and
(e) N⁺ doping, using said polysilicon gate strip as a mask, of the remaining part (12, 14) of said predetermined surface portion (6, 8) of the substrate for formation of a drain area (12, 14) with said N⁻ doped part (6, 8) under the polysilicon gate strip (10′, 10˝) and simultaneously of another surface portion (15, 13) of the substrate on the opposite side of said polysilicon gate strip (10′, 10˝) for formation of a source area (15, 13).

2. Process in accordance with claim 1
characterized in that said high-voltage N channel transistors include selection transistors and circuitry transistors, and in that for each circuitry transistor step (a) also provides for N⁻ doping of a further surface portion (7) of the substrate, in that in step (c) said polysilicon gate strip (10˝) is also formed on a side part of said further surface portion (7), which latter opposes said side part of said predetermined surface portion (8) and in that in step (e) said another surface portion (13) is the remaining part of said further surface portion (7).

## Patentansprüche

1. Verfahren zur gleichzeitigen Bildung einer Mehrzahl von N-Kanal-Transistoren für hohe Spannungen insbesondere für EEPROM-Speicher mit CMOS-Technologie, dadurch gekennzeichnet, daß es für jeden Transistor die nachfolgende Abfolge von Schritten umfaßt:
(a) N⁻-Dotierung eines vorbestimmten Oberflächenbereichs (6, 8) eines P-leitenden Halbleitersubstrats (1), wobei das Substrat zuvor mit Gate-Oxid (2) bedeckt worden ist,
(b) Oxidieren der Substratoberfläche,
(c) Aufbringen und Definieren einer N⁺-dotieren Polysiliziumschicht (10) zur Bildung eines Polysilizium-Gate-Streifens (10′, 10˝) auf einem Seitenbereich des vorbestimmten Oberflächenbereichs (6, 8) sowie auf einem benachbarten Oberflächenbereich des Substrats,
(d) Oxidieren des Polysilizium-Gate-Streifens (10′, 10˝), und
(e) unter Verwendung des Polysilizium-Gate-Streifens als Maske erfolgende N⁺-Dotierung des übrigen Teils (12, 14) des vorbestimmten Oberflächenbereichs (6, 8) des Substrats zur Bildung eines Drain-Bereichs (12, 14), wobei der N⁻-dotierte Bereich (6, 8) unter dem Polysilizium-Gate-Streifen (10′, 10˝) liegt, sowie gleichzeitig eines weiteren Oberflächenbereichs (15, 13) des Substrats auf der entgegengesetzten Seite des Polysilizium-Gate-Streifens (10′, 10˝) zur Bildung eines Source-Bereichs (15, 13).

2. Verfahren nach Anspruch 1,
dadurch gekennzeichnet, daß die N-Kanal-Transistoren für hohe Spannungen Auswähltransistoren und Transistoren für Schaltungseinrichtungen beinhalten und daß für jeden Auswähltransistor der Schritt (a) außerdem eine N⁻-Dotierung eines zusätzlichen Oberflächenbereichs (7) des Substrats beinhaltet, daß in Schritt (c) der Polysilizium-Gate-Streifen (10˝) auch auf einem Seitenbereich des zusätzlichen Oberflächenbereichs (7) ausgebildet wird, welcher dem Seitenbereich des vorbestimmten Oberflächenbereichs (8) gegenüberliegt, und daß in Schritt (e) der weitere Oberflächenbereich (13) der übrige Teil des zusätzlichen Oberflächenbereichs (7) ist.

## Revendications

1. Procédé de formation simultanée de plusieurs transistors haute tension à canal N, notamment pour des mémoires EEPROM utilisant la technologie CMOS, caractérisé en ce qu'il comprend successivement, pour chaque transistor, les étapes suivantes :
a) dopage N⁻ d'une partie prédéterminée (6, 8) de la surface d'un substrat semiconducteur (1) de type P, ce substrat étant au préalable couvert d'un oxyde de grille (2),
b) oxydation de la surface du substrat,
c) dépôt et délimitation d'une couche de silicium polycristallin (10) de dopage N⁺ pour la formation d'une bande de grille (10′, 10˝) de silicium polycristallin sur un côté de la partie prédéterminée (6, 8) de la surface et sur une partie adjacente de la surface du substrat,
d) oxydation de la bande de grille (10′, 10˝) de silicium polycristallin, et
e) dopage N⁺, en utilisant la bande de grille de silicium polycristallin en tant que masque, de la partie restante (12, 14) de la partie prédéterminée (6, 8) de la surface du substrat pour la formation d'une zone de drain (12, 14) avec la partie (6, 8) dopée N⁻ sous la bande de grille (10′, 10˝) de silicium polycristallin, et dopage N⁺ simultané d'une autre partie (15, 13) de la surface du substrat sur le côté opposé de la bande de grille (10′, 10˝) de silicium polycristallin pour la formation d'une zone de source (15, 13).

2. Procédé selon la revendication 1, caractérisé en ce que les transistors haute tension à canal N incluent des transistors de sélection et de circuit, en ce que pour chaque transistor de circuit, l'étape (a) réalise également le dopage N⁻ d'une partie supplémentaire (7) de la surface du substrat, en ce que dans l'étape (c) la bande de grille (10˝) de silicium polycristallin est également formée sur une partie latérale de cette partie supplémentaire (7) de la surface, laquelle partie latérale fait face à la partie prédéterminée (8) de la surface, et en ce que dans l'étape (e) l'autre partie (13) mentionnée de la surface représente la partie restante de la partie supplémentaire (7) de la surface.
